# EUROPEAN PATENT APPLICATION

(11) **EP 4 823 295 A1**
(43) Date of publication of application: **14.10.2026**
(21) Application number: 26168637.2
(22) Date of filing: 27.03.2026
(51) Int. Cl.: H10K 59/122, H10K 59/35, H10K 59/32, H10K 59/40, H10K 59/80, H10K 59/121, H10K 59/126

(54) **ELECTRONIC DEVICE**

(30) Priority: 10.04.2025 KR 20250046642
(71) Applicant: Samsung Display Co., Ltd., Yongin-si, Gyeonggi-do (KR)
(72) Inventor: Park, Seunghyun, Yongin-si, Gyeonggi-Do (KR); Kim, Deokhoi, Yongin-si, Gyeonggi-Do (KR); Kim, Choong-Hwa, Yongin-si, Gyeonggi-Do (KR); Kim, Tae Hyun, Yongin-si, Gyeonggi-Do (KR); Hwang, Jun-Hyuck, Yongin-si, Gyeonggi-Do (KR)
(74) Representative: Gulde & Partner

(57) **Abstract**

Disclosed is an electronic device (EDE, 10_3) including a base layer (110), a circuit layer (120) above the base layer (110), a light-emitting element layer (130) above the circuit layer (120), and including pixel electrodes (AE, CE), and a pixel definition film (PDL) defining openings (OP) respectively overlapping the pixel electrodes (AE, CE), the openings (OP) including a first opening (OP1) and a second opening (OP2) having shapes inclined at different angles in plan view, and a first separation pattern (VP1) surrounding at least a portion of the first opening (OP1), and a second separation pattern (VP2) surrounding at least a portion of the second opening (OP2), above an upper surface of the pixel definition film (PDL), the first separation pattern (VP1) and the second separation pattern (VP2) having a same shape.

## Description

### BACKGROUND

Embodiments of the present disclosure described herein relate to an electronic device with improved display quality.

Each of multimedia electronic devices, such as a TV, a mobile phone, a tablet personal computer (PC), a navigation system, a game console, and the like, includes a display panel for displaying an image. The display panel may include an organic light-emitting display panel. An organic light-emitting electronic device includes a light-emitting element, and the light-emitting element may generate light through a recombination of electrons and holes. An organic light-emitting display panel has a fast response speed, and may be driven with low power consumption.

### SUMMARY

Embodiments of the present disclosure provide an electronic device with improved display quality.

According to one or more embodiments, an electronic device may include a base layer, a circuit layer above the base layer, a light-emitting element layer above the circuit layer, and including pixel electrodes, and a pixel definition film defining openings respectively overlapping the pixel electrodes, the openings including a first opening and a second opening having shapes inclined at different angles in plan view, and a first separation pattern surrounding at least a portion of the first opening, and a second separation pattern surrounding at least a portion of the second opening, above an upper surface of the pixel definition film, the first separation pattern and the second separation pattern having a same shape.

The first opening and the second opening may have an elliptical shape, and a direction of a major axis of the first opening may be different from a direction of a major axis of the second opening.

The openings may further include a third opening adjacent to the first opening, and may further include a fourth opening adjacent to the second opening that may have a shape inclined at a different angle from that of the third opening, and the electronic device may further include a third separation pattern surrounding at least a portion of the third opening. The electronic device may further include a fourth separation pattern surrounding at least a portion of the fourth opening and that may have the same shape as that of the third separation pattern, above the upper surface of the pixel definition film.

A first distance between the first opening and the third opening may be different from a second distance between the second opening and the fourth opening, and a third distance between the first separation pattern and the third separation pattern may be substantially equal to a fourth distance between the second separation pattern and the fourth separation pattern.

The first separation pattern and the second separation pattern may have a shape of a portion of a circular ring in plan view.

The first separation pattern and the second separation pattern may have a shape of a portion of a polygonal ring in plan view.

The openings may further include a third opening adjacent to the first opening and a fifth opening adjacent to the first opening, and the first separation pattern may be between the first opening and the third opening and between the first opening and the fifth opening.

The openings may further include a third opening adjacent to the first opening and a fifth opening adjacent to the first opening, and the electronic device may further include a third separation pattern surrounding at least a portion of the third opening above the upper surface of the pixel definition film.

The first separation pattern and the third separation pattern may be between the first opening and the third opening, and the first separation pattern may be between the first opening and the fifth opening.

The first opening and the second opening may correspond to a first color emission area of a first color, the third opening may correspond to a second color emission area of a second color different from the first color, and the fifth opening corresponds to a third color emission area of a third color different from the first color and from the second color.

The electronic device may further include a reflection reduction layer above the light-emitting element layer, and that may include color filters that may include a first color filter overlapping the first opening and a second color filter overlapping the second opening, wherein the first color filter and the second color filter may have shapes inclined at different respective angles in plan view.

The first color filter and the second color filter may have an elliptical shape, and a direction of a major axis of the first color filter may be different from a direction of a major axis of the second color filter.

According to one or more embodiments, an electronic device may include a first light-emitting element corresponding to a first emission area, a second light-emitting element configured to output light of a same color as that of the first light-emitting element, and corresponding to a second emission area having a shape inclined at a different angle from that of the first emission area in plan view, and a pixel definition film defining a first separation pattern surrounding at least a portion of the first emission area, and a second separation pattern surrounding at least a portion of the second emission area and having a same shape as that of the first separation pattern.

The first emission area and the second emission area may have an elliptical shape, and a direction of a major axis of the first emission area may be different from a direction of a major axis of the second emission area.

The first separation pattern and the second separation pattern may have a shape of a portion of a circular ring in plan view.

The first separation pattern and the second separation pattern may have a shape of a portion of a polygonal ring in plan view.

According to one or more embodiments, an electronic device may include a display panel configured to display an image, and a processor configured to control an operation of the display panel, wherein the display panel includes a base layer, a circuit layer above the base layer, a light-emitting element layer including a pixel definition film defining openings, and defining first emission areas including a (1-1)-th sub-emission area, and second emission areas including a (2-1)-th sub-emission area having a shape inclined at a different angle from that of the (1-1)-th sub-emission area, and a first separation pattern surrounding at least a portion of the (1-1)-th sub-emission area, and a second separation pattern surrounding at least a portion of the (2-1)-th sub-emission area and having a same shape as the first separation pattern in plan view, above an upper surface of the pixel definition film.

The first emission areas may further include a (1-2)-th sub-emission area, the second emission areas may further include a (2-2)-th sub-emission area, and a third separation pattern surrounding at least a portion of the (1-2)-th sub-emission area and a fourth separation pattern surrounding at least a portion of the (2-2)-th sub-emission area on the upper surface of the pixel definition film.

A first interval between the (1-1)-th sub-emission area and the (1-2)-th sub-emission area may be different from a second interval between the (2-1)-th sub-emission area and the (2-2)-th sub-emission area.

A third interval between the first separation pattern and the third separation pattern may be substantially equal to a fourth interval between the second separation pattern and the fourth separation pattern.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects of the present disclosure will become apparent by describing in detail embodiments thereof with reference to the accompanying drawings.
FIG. 1 is a block diagram of an electronic device according to one or more embodiments of the present disclosure.
FIG. 2 illustrates schematic views of an electronic device according to various embodiments of the present disclosure.
FIG. 3 is a perspective view of an electronic device according to one or more embodiments of the present disclosure.
FIG. 4 is a schematic cross-sectional view of an electronic device according to one or more embodiments of the present disclosure.
FIG. 5 is a block diagram illustrating some components of an electronic device according to one or more embodiments of the present disclosure.
FIG. 6 is a cross-sectional view of an electronic device according to one or more embodiments of the present disclosure.
FIG. 7 is a cross-sectional view of a light-emitting element according to one or more embodiments of the present disclosure.
FIG. 8 is a plan view illustrating openings and a plurality of first electrodes defined in a pixel definition film according to one or more embodiments of the present disclosure.
FIG. 9 is a plan view illustrating openings, separation patterns, and a plurality of first electrodes defined in a pixel definition film according to one or more embodiments of the present disclosure.
FIG. 10 is a plan view illustrating openings, separation patterns, and a plurality of first electrodes defined in a pixel definition film according to one or more embodiments of the present disclosure.
FIG. 11 is a plan view illustrating openings, separation patterns, and a plurality of first electrodes defined in a pixel definition film according to one or more embodiments of the present disclosure.
FIG. 12 is a plan view illustrating openings, separation patterns, and a plurality of first electrodes defined in a pixel definition film according to one or more embodiments of the present disclosure.
FIG. 13 is a plan view illustrating openings and color filters defined in a pixel definition film according to one or more embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between first and second objects, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the scope of the present disclosure as defined by the appended claims. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same." In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure as defined by the appended claims. In addition, in some embodiments, the block, unit and/or module may be physically combined into more complex blocks, units, and/or modules without departing from the scope of the present disclosure as defined by the appended claims.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

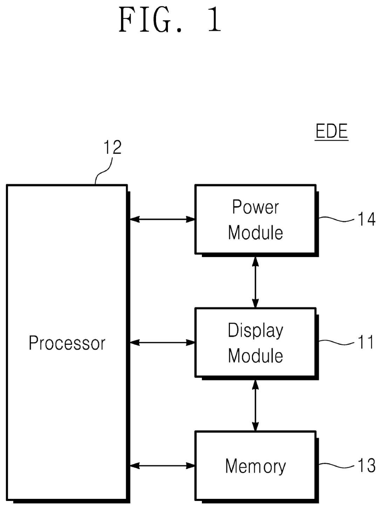

FIG. 1 is a block diagram of an electronic device EDE according to one or more embodiments of the present disclosure.

Referring to FIG. 1, the electronic device EDE may include a display module 11, a processor 12, a memory 13, and a power module 14.

The display module 11 may display an image. The image may include a still image as well as a moving image. The processor 12 may include at least one of a central processing unit (CPU), an application processor (AP), a graphic processing unit (GPU), a communication processor (CP), an image signal processor (ISP), or a controller. The processor 12 may be configured to control an operation of the display module 11.

Data information that are suitable for an operation of the processor 12 or the display module 11 may be stored in the memory 13. When the processor 12 executes an application stored in the memory 13, an image data signal and/or an input control signal may be transmitted to the display module 11, and the display module 11 may process the provided signal and output image information through a display screen.

The power module 14 may include a power module, such as a power adapter or a battery device, and a power conversion module that converts electric power supplied by the power module to generate electric power that is suitable for an operation of the electronic device EDE.

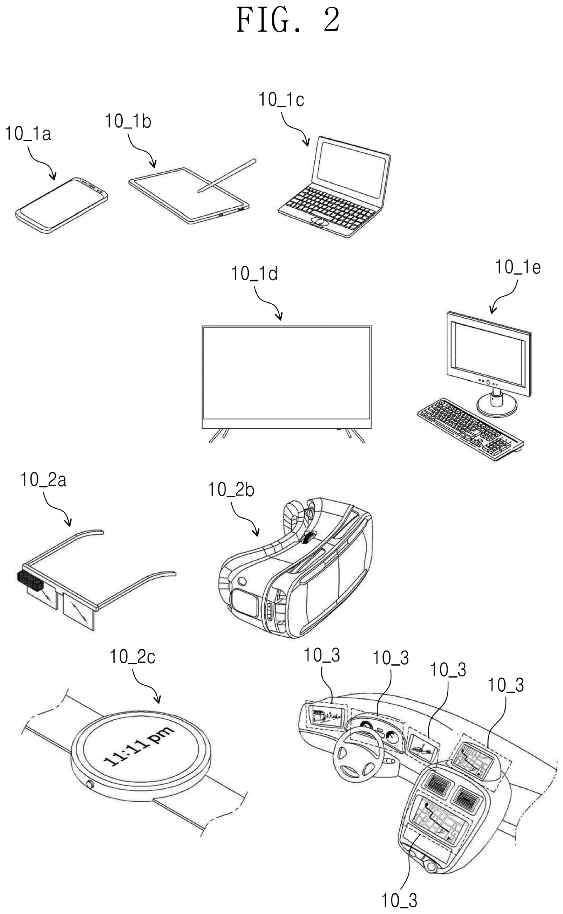

FIG. 2 illustrates schematic views of an electronic device according to various embodiments of the present disclosure.

Referring to FIG. 2, various electronic device, to which the displays according to embodiments of the present disclosure are applied, may include not only an electronic device for displaying an image, such as a smartphone 10_1a, a tablet PC 10_1b, a laptop computer 10_1c, a TV 10_1d, and a monitor 10_1e for a desk, but also may include a wearable electronic device including a display module, such as smart glasses 10_2a, a head-mounted display 10_2b, and a smart watch 10_2c, and an electronic device 10_3 for a vehicle including a display module, such as a center information display located in an instrument panel for a vehicle, a center fascia, and a dash board, and a room mirror display.

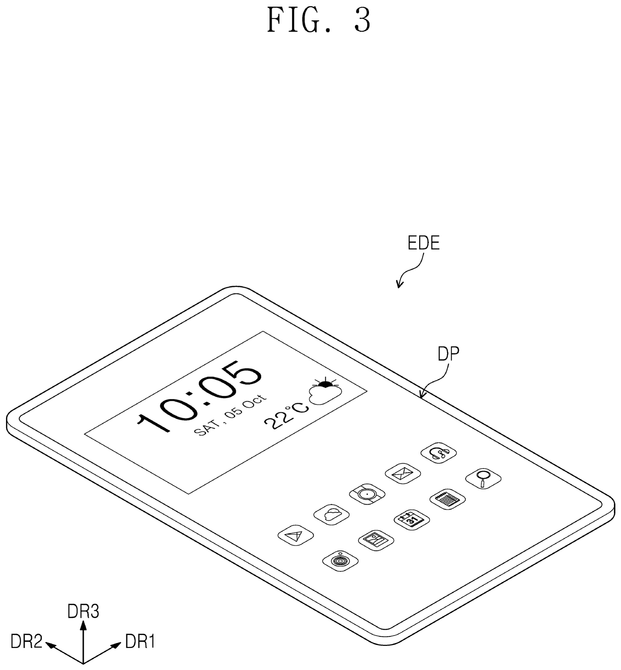

FIG. 3 is a perspective view of an electronic device EDE according to one or more embodiments of the present disclosure.

Referring to FIG. 3, the electronic device EDE may be a device activated depending on an electrical signal. For example, the electronic device EDE may include a display panel DP. The display panel DP displays an image, and may sense inputs that are applied from the outside. The external input may be an input by the user. The user input may include various types of external inputs, such as a part of a user body, light, heat, or pressure.

The display panel DP may have a plane that is substantially parallel to a first direction DR1 and a second direction DR2. A thickness direction of the electronic device EDE may be parallel to a third direction DR3 that crosses the first direction DR1 and the second direction DR2. Accordingly, a front surface (or an upper surface) and a rear surface (or a lower surface) of the members that constitute the electronic device EDE may be defined with respect to the third direction DR3.

Although FIG. 3 illustrates an example of a bar type electronic device EDE, the present disclosure described below is not limited thereto. For example, the descriptions made below may be applied to various electronic devices, such as a foldable electronic device, a rollable electronic device, a slidable electronic device, and a stretchable electronic device.

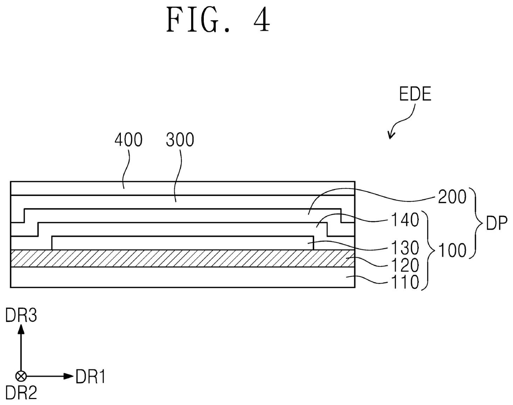

FIG. 4 is a schematic cross-sectional view of an electronic device EDE according to one or more embodiments of the present disclosure.

Referring to FIG. 4, the electronic device EDE may include a display panel DP, a reflection reduction layer (e.g., reflection-preventing layer) 300, and a window 400. The display panel DP may include a display layer 100 and a sensor layer 200.

The display layer 100 may include a base layer 110, a circuit layer 120, a light-emitting element layer 130, and an encapsulation layer 140.

The base layer 110 may be a member that provides a base surface on which the circuit layer 120 is located. The base layer 110 may be a rigid substrate, or a flexible substrate capable of bending, folding, rolling, or the like. The base layer 110 may be a glass substrate, a metal substrate, a silicon substrate, a polymer substrate, or the like. However, the present disclosure is not limited thereto, but the base layer 110 may be an inorganic layer, an organic layer, or a composite material layer.

The circuit layer 120 may be located on the base layer 110 (as used herein, "located on" may mean "above"). The circuit layer 120 may include an insulating layer, a semiconductor pattern, a conductive pattern, and a signal line. The insulating layer, the semiconductor layer, and the conductive layer may be formed on the base layer 110 in a manner, such as coating, deposition, or the like. Afterward, the insulating layer, the semiconductor layer, and the conductive layer may be selectively patterned by performing a photolithography process multiple times. Afterward, the semiconductor pattern, the conductive pattern, and the signal line included in the circuit layer 120 may be formed.

The light-emitting element layer 130 may be located on the circuit layer 120. The light-emitting element layer 130 may include a light-emitting element. For example, the light-emitting element layer 130 may include an organic light-emitting material, an inorganic light-emitting material, or an organic-inorganic light-emitting material.

An encapsulation layer 140 may be located on the light-emitting element layer 130. The encapsulation layer 140 may protect the light-emitting element layer 130 from foreign substances, such as moisture, oxygen, and dust particles.

The sensor layer 200 may be located on the display layer 100. The sensor layer 200 may be formed on the display layer 100 through a successive process. In this case, the sensor layer 200 may be expressed as being directly located on the display layer 100. "Being directly located" may mean that no third component is interposed between the sensor layer 200 and the display layer 100. That is, there might be no separate adhesive member interposed between the sensor layer 200 and the display layer 100. Alternatively, the sensor layer 200 may be coupled to the display layer 100 through an adhesive member. The adhesive member may include a typical adhesive or a sticking agent.

The reflection reduction layer 300 may be located on the sensor layer 200. The reflection reduction layer 300 may reduce the reflectance of external light incident from the outside of the electronic device EDE. The reflection reduction layer 300 may be directly located on the sensor layer 200. In this case, the reflection reduction layer 300 may be regarded as a component included in the display panel DP. However, the present disclosure is not limited thereto, and an adhesive material may be located between the reflection reduction layer 300 and the sensor layer 200.

The reflection reduction layer 300 may include color filters. The color filters may have a given arrangement. For example, the color filters may be arranged in consideration of emission colors of pixels included in the display layer. Besides, the reflection reduction layer 300 may further include a black matrix adjacent to the color filters.

The window 400 may be located on the reflection reduction layer 300. An adhesive material may be located between the reflection reduction layer 300 and the window 400, but the present disclosure is not particularly limited thereto. The window 400 may include an optically transparent insulating material. For example, the window 400 may include glass or plastic. The window 400 may have a single-layer structure or a multi-layer structure. For example, the window 400 may include a plurality of plastic films bonded through an adhesive or may include a glass substrate and a plastic film that are bonded through an adhesive.

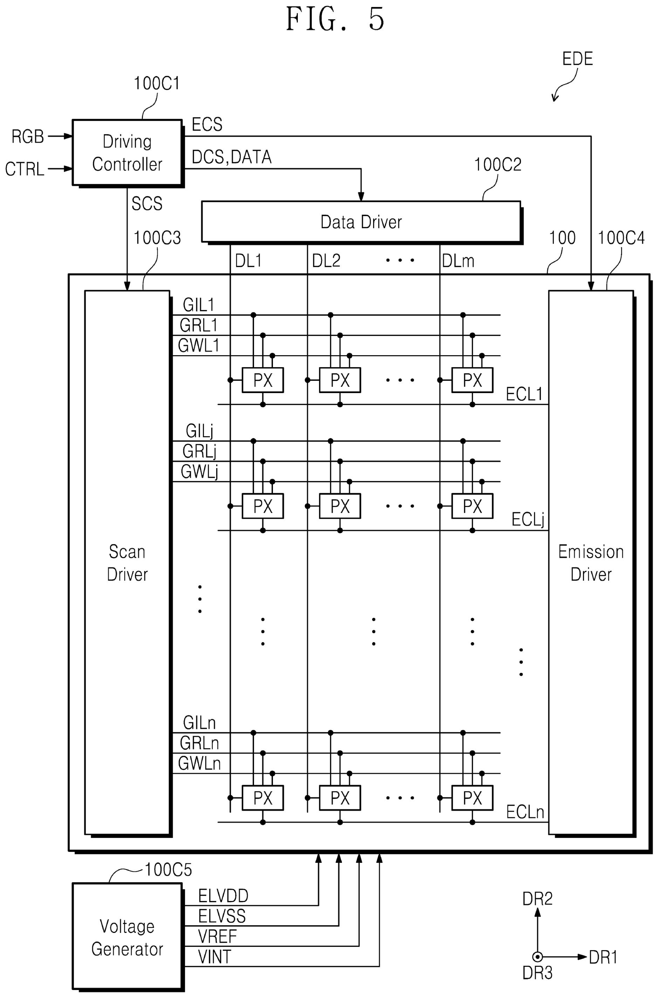

FIG. 5 is a block diagram illustrating some components of an electronic device EDE according to one or more embodiments of the present disclosure.

Referring to FIG. 5, the electronic device EDE includes a display layer 100, a driving controller 100C1, a data driver 100C2, a scan driver 100C3, an emission driver 100C4, and a voltage generator 100C5.

The display layer 100 may include a plurality of pixels PX, scan lines GIL1 to GILn, GRL1-GRLn, and GWL1-GWLn, emission control lines ECL1 to ECLn, and data lines DL1-DLm.

The pixels PX may be located in an active area of the display layer 100. Each of the plurality of pixels PX may be electrically connected to three scan lines, one emission control line, and one data line. For example, as illustrated in FIG. 5, the pixels PX of a first row may be connected to scan lines GILL, GRL1, and GWL1 and an emission control line ECL1. Furthermore, the pixels of a j-th row may be connected to scan lines GILj, GRLj, and GWLj and an emission control line ECLj.

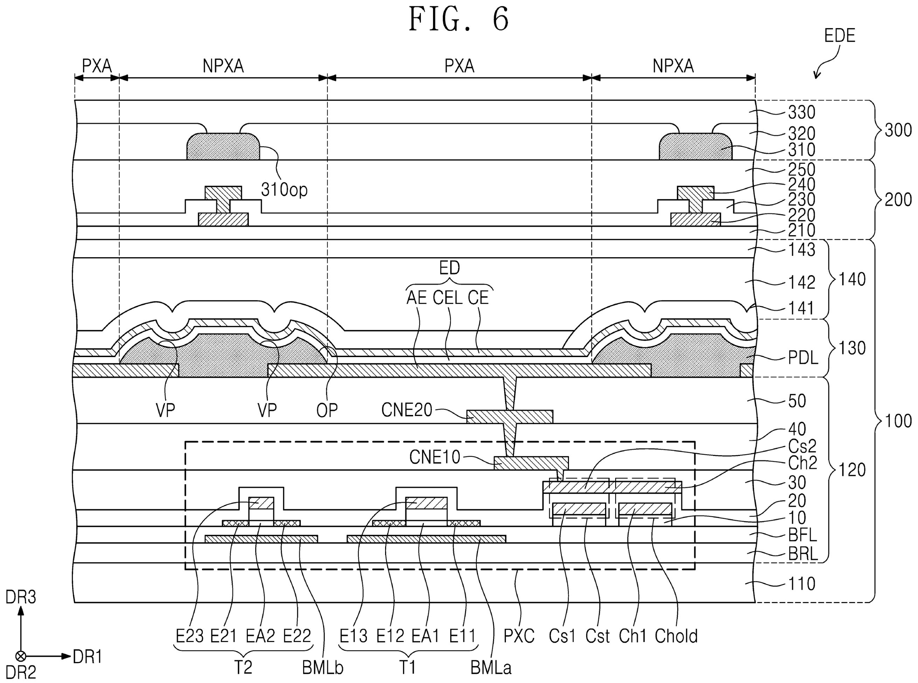

Each of the plurality of pixels PX includes a light-emitting element ED (see FIG. 6) and a pixel circuit PXC (see FIG. 6) that controls light emission of the light-emitting element ED. The pixel circuit PXC may include one or more thin film transistors and one or more capacitors.

The scan driver 100C3 and the emission driver 100C4 may be embedded in the display layer 100. Accordingly, the display layer 100 may include the scan driver 100C3 and the emission driver 100C4. The scan driver 100C3 and the emission driver 100C4 may include thin film transistors that is formed through the same process as that of the pixel circuit PXC.

In one or more embodiments of the present disclosure, the pixels PX, the scan driver 100C3, and the emission driver 100C4 may not overlap each other. However, the present disclosure is not limited thereto, and at least some of the pixels PX may overlap the scan driver 100C3 and the emission driver 100C4. In this case, at least a portion of the scan driver 100C3 and at least a portion of the emission driver 100C4 may be located in the display area.

The driving controller 100C1 receives an input image signal RGB and a control signal CTRL. The driving controller 100C1 generates an output image signal DATA by converting a data format of the input image signal RGB such that the data format is suitable for the interface specification of the data driver 100C2. The driving controller 100C1 outputs a scan driving signal SCS, a data driving signal DCS, and an emission driving signal ECS.

The data driver 100C2 receives a data driving signal DCS and an output image signal DATA from the driving controller 100C1. The data driver 100C2 converts the output image signal DATA into data signals, and outputs the data signals to a plurality of data lines DL1 to DLm that will be described below. The data signals are analog voltages corresponding to grayscale values of the output image signal DATA.

The scan driver 100C3 receives a scan driving signal SCS from the driving controller 100C1. The scan driver 100C3 may output scan signals to scan lines GIL1 to GILn, GRL1-GRLn, and GWL1 to GWLn in response to the scan driving signal SCS. The scan lines GIL1 to GILn may be referred to as first initialization scan lines GIL1 and GILn, and scan lines GRL1 to GRLn may be referred to as compensation scan lines GRL1 to GRLn, and scan lines GWL1 to GWLn may be referred to as write scan lines GWL1 to GWLn.

The emission driver 100C4 receives an emission driving signal ECS from the driving controller 100C1. The emission driver 100C4 may output emission control signals to the emission control lines ECL1 to ECLn in response to the emission driving signal ECS.

The scan driver 100C3 is arranged on a first side of the display layer 100. The scan lines GIL1 to GILn, GRL1 to GRLn, and GWL1 to GWLn extend from the scan driver 100C3 in the first direction DR1. The emission driver 100C4 is arranged on a second side of the display layer 100. The emission control lines ECL1 to ECLn extend from the emission driver 100C4 in an opposite direction to the first direction DR1.

Each of the scan lines GIL1 to GILn, GRL1 to GRLn, and GWL1 to GWLn and each of the emission control lines ECL1 to ECLn are arranged to be spaced apart from each other in the second direction DR2. The data lines DL1 to DLm (such as a data line DL2) extend from the data driver 100C2 in an opposite direction to the second direction DR2, and are arranged to be spaced apart from each other in the first direction DR1.

In the example illustrated in FIG. 5, the scan driver 100C3 and the emission driver 100C4 are arranged to face each other with pixels PX interposed therebetween, but the present disclosure is not limited thereto. For example, the scan driver 100C3 and the emission driver 100C4 may be located adjacent to each other on either the first side or the second side of the display layer 100. In one or more embodiments of the present disclosure, the scan driver 100C3 and the emission driver 100C4 may be configured as a single circuit.

The voltage generator 100C5 generates voltages suitable for the operation of the display layer 100. In one or more embodiments of the present disclosure, the voltage generator 100C5 generates a first driving voltage ELVDD, a second driving voltage ELVSS, a reference voltage VREF, and an initialization voltage VINT. Each of the plurality of pixels PX receives the first driving voltage ELVDD, the second driving voltage ELVSS, the reference voltage VREF, and the initialization voltage VINT from the voltage generator 100C5.

FIG. 6 is a cross-sectional view of an electronic device EDE according to one or more embodiments of the present disclosure.

Referring to FIG. 6, the circuit layer 120 may be located on the base layer 110. The circuit layer 120 may include a barrier layer BRL, a buffer layer BFL, first to fifth insulating layers 10, 20, 30, 40, and 50, and a pixel circuit PXC that are sequentially laminated on the base layer 110. In FIG. 6, two thin film transistors T1 and T2 and two capacitors Cst and Chold in the pixel circuit PXC are illustrated by way of example.

The barrier layer BRL may be located on the base layer 110. The barrier layer BRL may have a single layer or multi-layer structure. For example, the barrier layer BRL may include at least one of silicon oxide, silicon nitride, silicon oxynitride, or amorphous silicon.

The lower conductive layers BMLa and BMLb may be located on the barrier layer BRL. However, the present disclosure is not particularly limited. For example, when the barrier layer BRL has a multi-layer structure, the lower conductive layers BMLa and BMLb may be located between the layers that constitute the barrier layer BRL. Furthermore, although FIG. 6 illustrates that each of the lower conductive layers BMLa and BMLb is provided as a single layer, by way of example, each of the lower conductive layers BMLa and BMLb may include a plurality of layers.

Each of the lower conductive layers BMLa and BMLb may include a reflective metal. For example, each of the lower conductive layers BMLa and BMLb may include titanium (Ti), molybdenum (Mo), an alloy containing molybdenum, aluminum (AL), an alloy containing aluminum, aluminum nitride (AIN), tungsten (W), tungsten nitride (WN), and/or copper (Cu). An effect on the thin film transistors T1 and T2 of an electric potential of each of the lower conductive layers BMLa and BMLb due to the polarization phenomenon of the base layer 110 may be reduced or prevented. Furthermore, each of the lower conductive layers BMLa and BMLb may block light incident on the thin film transistors T1 and T2 from below.

In one or more embodiments of the present disclosure, the first lower conductive layer BMLa located under a first thin film transistor T1 and the second lower conductive layer BMLb located under a second thin film transistor T2 may be electrically isolated from each other. For example, the first lower conductive layer BMLa located under the first thin film transistor T1 may be synchronized with a second electrode E12 of the first thin film transistor T1. The second lower conductive layer BMLb located under the second thin film transistor T2 may be synchronized with a second gate electrode E23 of the second thin film transistor T2. However, this is only an example, and the present disclosure is not particularly limited thereto. For example, each of the lower conductive layers BMLa and BMLb may independently receive a constant voltage or a pulse signal. Alternatively, each of the lower conductive layers BMLa and BMLb may be provided in a form, in which it is isolated from other conductive patterns. Each of the lower conductive layers BMLa and BMLb according to one or more embodiments of the present disclosure may be provided in various forms, and is not limited to any one or more embodiments.

The buffer layer BFL may be located on the barrier layer BRL. The buffer layer BFL may reduce or prevent metal atoms or impurities being spread into a semiconductor pattern. In addition, the buffer layer BFL may adjust the speed of applying heat during a crystallization process for forming the semiconductor pattern, such that the semiconductor pattern is uniformly formed. The buffer layer BFL may include a plurality of inorganic layers. For example, the buffer layer BFL may include a first sub buffer layer including silicon nitride, and a second sub-buffer layer that is located on the first sub-buffer layer and includes silicon oxide.

The semiconductor pattern layers EA1, E11, E12, EA2, E21, and E22 may be located on the buffer layer BFL. The semiconductor pattern layers EA1, E11, E12, EA2, E21, and E22 may include a metal oxide. The metal oxide semiconductor may include a crystalline or amorphous oxide semiconductor. For example, the oxide semiconductor may include oxides of metals (e.g., zinc (Zn), indium (In), gallium (Ga), tin (Sn), titanium (Ti), and/or the like) or a mixture of the metals (e.g., zinc (Zn), indium (In), gallium (Ga), tin (Sn), titanium (Ti), and/or the like) and oxides of the metals. The oxide semiconductors may include indium-tin oxide (ITO), indium-gallium-zinc oxide (IGZO), zinc oxide (ZnO), indium-zinc oxide (IZnO), zinc-indium oxide (ZIO), indium oxide (InO), titanium oxide (TiO), indium-zinc-tin oxide (IZTO), zinc-tin oxide (ZTO), and/or the like.

The semiconductor pattern layers EA1, E11, E12, EA2, E21, and E22 may include a plurality of areas that are distinguished depending on whether a metal oxide is reduced. An area (hereinafter referred to as a "reduction area") in which the metal oxide is reduced has higher conductivity than an area (hereinafter referred to as a "non-reduction area") in which the metal oxide is not reduced. The reduction area substantially serves as a source/drain area of a thin film transistor or a signal line. The non-reduction area substantially corresponds to a semiconductor area (or channel) of a thin film transistor. In other words, a part of the semiconductor pattern may be the semiconductor area of the thin film transistor, another part may be the source/drain of the thin film transistor, and the other part may be the signal transmission area.

The semiconductor pattern layers EA1, E11, E12, EA2, E21, and E22 may include a first channel area EA1, a first electrode E11 and a second electrode E12 of a first thin film transistor T1, and a second channel area EA2, a first electrode E21 and a second electrode E22 of a second thin film transistor T2. The first and second channel areas EA1 and EA2 may be non-reduction areas. The first electrode E11 and the second electrode E12 of the first thin film transistor T1 may be a source area and a drain area of the first thin film transistor T1, respectively. The first electrode E21 and the second electrode E22 of the second thin film transistor T2 may be a source area and a drain area of the second thin film transistor T2, respectively. The first electrode E11 and the second electrode E12 of the first thin film transistor T1, and the first electrode E21 and the second electrode E22 of the second thin film transistor T2 may be reduction areas.

A first insulating layer 10 may be located on the first and second channel areas EA1 and EA2. In one or more embodiments of the present disclosure, the first insulating layer 10 may overlap only a corresponding conductive pattern. For example, the first insulating layer 10 may be located only in an area that overlaps a conductive layer directly located on the first insulating layer 10. FIG. 6 illustrates, by way of example, that the first insulating layer 10 is located only in an area that overlaps the first gate electrode E13 of the first thin film transistor T1, the second gate electrode E23 of the second thin film transistor T2, a first counter electrode Cs1 of a transfer capacitor Cst, and a first holding counter electrode Ch1 of a holding capacitor Chold. However, one or more embodiments is not particularly limited thereto. For example, the first insulating layer 10 may also overlap the entire base layer 110.

The second insulating layer 20 is located on the buffer layer BFL, and may cover the first insulating layer 10, the first gate electrode E13 of the first thin film transistor T1, the second gate electrode E23 of the second thin film transistor T2, the first counter electrode Cs1 of the transfer capacitor Cst, and the first holding counter electrode Ch1 of the holding capacitor Chold.

Each of the first insulating layer 10 and the second insulating layer 20 may be an inorganic layer, and may have a single-layer or multi-layer structure. Each of the first insulating layer 10 and the second insulating layer 20 may include at least one of an aluminum oxide, a titanium oxide, a silicon oxide, a silicon nitride, a silicon oxynitride, a zirconium oxide, or a hafnium oxide. In one or more embodiments of the present disclosure, each of the first insulating layer 10 and the second insulating layer 20 may be a single-layer silicon oxide layer.

The second counter electrode Cs2 of the transfer capacitor Cst and the second holding counter electrode Ch2 of the holding capacitor Chold may be located on the second insulating layer 20. The second counter electrode Cs2 and the second holding counter electrode Ch2 may be connected to each other to have an integral shape.

The third insulating layer 30 may be on the second insulating layer 20, and may cover the second counter electrode Cs2 and the second holding counter electrode Ch2. The third insulating layer 30 may be an inorganic layer, and may have a single layer structure or a multi-layer structure. The third insulating layer 30 may include at least one of an aluminum oxide, a titanium oxide, a silicon oxide, a silicon nitride, a silicon oxynitride, a zirconium oxide, or a hafnium oxide.

The first connection electrode CNE10 may be located on the third insulating layer 30. The first connection electrode CNE10 may be connected to the second counter electrode Cs2 through a contact hole that passes through the third insulating layer 30.

The fourth insulating layer 40 may be located on the third insulating layer 30. The fourth insulating layer 40 may be an organic layer. The second connection electrode CNE20 may be located on the fourth insulating layer 40. The second connection electrode CNE20 may be connected to the first connection electrode CNE10 through a contact hole that passes the fourth insulating layer 40. The fifth insulating layer 50 may be located on the fourth insulating layer 40, and may cover the second connection electrode CNE20. The fifth insulating layer 50 may be an organic layer.

Each of the fourth insulating layer 40 and the fifth insulating layer 50 may include general purpose polymers, such as benzocyclobutene (BCB), polyimide, hexamethyldisiloxane (HMDSO), polymethylmethacrylate (PMMA) or polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, and/or the blend thereof, but is not particularly limited thereto.

The light-emitting element layer 130 may be located on the circuit layer 120. The light-emitting element layer 130 may include a light-emitting element ED. In FIG. 6, one light-emitting element ED is representatively illustrated. An emission area PXA may be defined to correspond to the light-emitting element ED. The emission area PXA may be defined by a pixel definition film PDL that will be described later.

The light-emitting element ED may include a first electrode AE, an intermediate layer CEL, and a second electrode CE. The first electrode AE may be referred to as a "pixel electrode" or "anode." The second electrode CE may be referred to as a "common electrode" or "cathode." The intermediate layer CEL may include a functional layer that is commonly provided to pixels PX (see FIG. 5) and an emission layer that is patterned to correspond to each of the pixels PX.

The first electrode AE may be located on the fifth insulating layer 50. The first electrode AE may be connected to the second connection electrode CNE20 through a contact hole that passes through the fifth insulating layer 50. The first electrode AE may be a transmissive (semi-transmissive) electrode or a reflective electrode. According to one or more embodiments of the present disclosure, the first electrode AE may include a reflective layer formed of silver, magnesium, aluminum, platinum, palladium, gold, nickel, neodymium, iridium, chromium, or a compound thereof, and a transparent or semi-transparent electrode layer formed on the reflective layer. The transparent or semi-transparent electrode layer may include at least one or more selected from a group including indium tin oxide, indium zinc oxide, indium gallium zinc oxide, zinc oxide or indium oxide, and aluminum-doped zinc oxide. For example, the first electrode AE may include a multi-layer structure in which indium tin oxide, silver, and indium tin oxide are sequentially stacked.

The pixel definition film PDL may be located on the fifth insulating layer 50. The pixel definition film PDL may have a property of absorbing light, and for example, the pixel definition film PDL may have a black color. The pixel definition film PDL may include a black coloring agent. The black coloring agent may include a black dye and a black pigment. The black coloring agent may include carbon black, a metal, such as chromium, or an oxide thereof. The material that constitutes the pixel definition film PDL is not limited thereto.

An opening OP that exposes a portion of the first electrode AE may be defined in the pixel definition film PDL. That is, the pixel definition film PDL may cover a periphery of the first electrode AE. An emission area PXA may be defined by the pixel definition film PDL. Furthermore, separation patterns VP overlapping a non-emission area NPXA may be defined in the pixel definition film PDL. The separation patterns VP may have a shape that is recessed in a third direction DR3, which is a thickness direction, from an upper surface of the pixel definition film PDL. A depth of each of the separation patterns VP may be less than a thickness of the pixel definition film PDL. Accordingly, side and bottom surfaces of each of the separation patterns VP may be defined by the pixel definition film PDL.

In one or more embodiments of the present disclosure, the separation patterns VP may have a shape that protrudes from an upper surface of the pixel definition film PDL. In this case, each of the side surfaces and the upper surface of the separation patterns VP may have a shape that protrudes from the pixel definition film PDL.

The intermediate layer CEL may be located on the first electrode AE and the pixel definition film PDL. The second electrode CE may be located on the intermediate layer CEL. The intermediate layer CEL and the second electrode CE may be located in the opening OP of the pixel definition film PDL and the separation patterns VP of the pixel definition film PDL.

According to one or more embodiments of the present disclosure, the thickness of the intermediate layer CEL and the thickness of the second electrode CE may become less due to the separation patterns VP. The thickness of the intermediate layer CEL located in the separation patterns VP may be less than the thickness of the intermediate layer CEL located on the upper surface of the pixel definition film PDL. Alternatively, a portion of the intermediate layer CEL may be cut off at a portion that overlaps the separation patterns VP. Furthermore, the thickness of the second electrode CE located in the separation patterns VP may become less than the thickness of the second electrode CE located on the upper surface of the pixel definition film PDL.

As the thicknesses of the intermediate layer CEL and the second electrode CE decreases, the resistances of the intermediate layer CEL and the second electrode CE increase at the portion that overlaps the separation patterns VP. Accordingly, current leakage into the area beyond the separation patterns VP may be reduced or prevented.

An encapsulation layer 140 may be located on the light-emitting element layer 130. The encapsulation layer 140 may include an organic layer, and a plurality of inorganic layers that seal the organic layer. For example, the encapsulation layer 140 may include a first encapsulation layer 141, a second encapsulation layer 142, and a third encapsulation layer 143 that are sequentially stacked, and the present disclosure is not limited particularly. The first and third encapsulation layers 141 and 143 may protect the light-emitting element layer 130 from moisture and oxygen, and the second encapsulation layer 142 may protect the light-emitting element layer 130 from a foreign material, such as dust particles. For example, the first and third encapsulation layers 141 and 143 may be inorganic encapsulation layers, and the second encapsulation layer 142 may be an organic encapsulation layer.

The sensor layer 200 may be located on the display layer 100. The sensor layer 200 may be referred to as a sensor, an input-sensing layer, or an input-sensing panel. The sensor layer 200 may have a function of sensing an external input. For example, the sensor layer 200 may be configured to sense at least one of an active input by an input device or a passive input by a touch.

The sensor layer 200 may include a sensor base layer 210, a first conductive layer 220, an intermediate insulating layer 230, a second conductive layer 240, and a sensor cover layer 250.

The sensor base layer 210 may be directly located on the display layer 100. The sensor base layer 210 may be an inorganic layer including at least one of silicon nitride, silicon oxynitride, or silicon oxide. Alternatively, the sensor base layer 210 may be an organic layer including an epoxy resin, an acrylate resin, or an imide-based resin. The sensor base layer 210 may have a single layer structure or may have a multi-layer structure stacked in the third direction DR3.

Each of the first conductive layer 220 and the second conductive layer 240 may have a single layer structure, or may have a multi-layer structure, in which layers are laminated in the third direction DR3.

A conductive layer of a single layer structure may include a metal layer or a transparent conductive layer. The metal layer may include molybdenum, silver, titanium, copper, aluminum, or an alloy thereof. The transparent conductive layer may include transparent conductive oxide, such as indium tin oxide, indium zinc oxide, zinc oxide, or indium zinc tin oxide. The transparent conductive layer may include a conductive polymer, such as PEDOT, a metal nano wire, graphene, and the like.

A conductive layer of the multi-layer structure may include metal layers. For example, the metal layers may have a three-layer structure of titanium/aluminum/titanium. The conductive layer of the multi-layer structure may include at least one metal layer and at least one transparent conductive layer.

The intermediate insulating layer 230 may be interposed between the first conductive layer 220 and the second conductive layer 240. The sensor cover layer 250 may be located on the intermediate insulating layer 230 to cover the second conductive layer 240. The second conductive layer 240 may include a conductive pattern. The sensor cover layer 250 may cover the conductive pattern and may reduce or eliminate the probability that the conductive pattern is damaged in a subsequent process.

The intermediate insulating layer 230 and the sensor cover layer 250 may include an inorganic film. The inorganic film may include at least one of aluminum oxide, titanium oxide, silicon oxide, silicon nitride, silicon oxynitride, zirconium oxide, or hafnium oxide.

Alternatively, the intermediate insulating layer 230 and the sensor cover layer 250 may include an organic film. The organic film may include at least one of acrylate-based resin, methacrylate-based resin, polyisoprene, vinyl-based resin, epoxy-based resin, urethane-based resin, cellulose-based resin, siloxane-based resin, polyimide-based resin, polyamide-based resin, or perylene-based resin.

The reflection reduction layer 300 may be located on the sensor layer 200. The reflection reduction layer 300 may include a division layer 310, a plurality of color filters 320, and a planarization layer 330.

The division layer 310 may be located to overlap the conductive pattern of the second conductive layer 240. The sensor cover layer 250 may be interposed between the division layer 310 and the second conductive layer 240. The division layer 310 may reduce or prevent reflection of external light by the second conductive layer 240. As long as a material absorbs light, the material constituting the division layer 310 is not particularly limited thereto. The division layer 310 may be a layer having a black color and, in one or more embodiments of the present disclosure, the division layer 310 may include a black coloring agent. The black coloring agent may include a black dye and a black pigment. The black coloring agent may include carbon black, a metal, such as chromium, or an oxide thereof.

A plurality of division openings 310op may be defined in the division layer 310. The division openings 310op may overlap the light-emitting elements ED in a one-to-one correspondence. In one or more embodiments of the present disclosure, the division layer 310 may be omitted.

The color filters 320 may overlap the light-emitting elements ED. For example, the color filters 320 may overlap the division opening 310op. The color filters 320 may transmit light provided from each corresponding light-emitting element ED.

The planarization layer 330 may cover the division layer 310 and the color filter 320. The planarization layer 330 may include an organic material, and may provide a planarized surface on an upper surface of the planarization layer 330. In one or more embodiments of the present disclosure, the planarization layer 330 may be omitted.

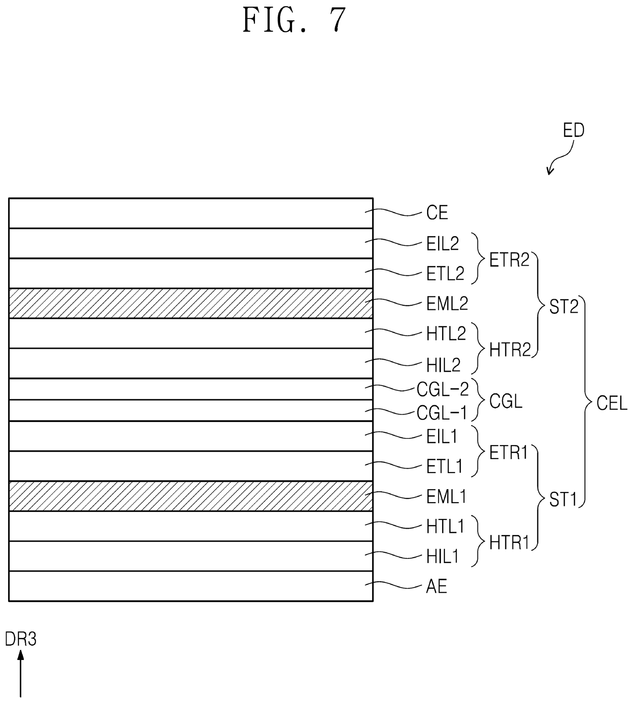

FIG. 7 is a cross-sectional view of a light-emitting element ED according to one or more embodiments of the present disclosure. FIG. 7 briefly illustrates a lamination structure of the light-emitting element ED illustrated in FIG. 6.

Referring to FIG. 7, the light-emitting element ED may include a first electrode AE, a first emission stack ST1, a charge-generating layer CGL, a second emission stack ST2, and a second electrode CE that are sequentially laminated in a third direction DR3. The light-emitting element ED may be a light-emitting element having a tandem structure including a plurality of emission stacks ST1 and ST2 including emission layers. FIG. 7 illustrates, by way of example, that the light-emitting element ED includes two emission stacks ST1 and ST2 and one charge-generating layer CGL located therebetween, but the present disclosure is not limited thereto. For example, the light-emitting element ED may include only one emission stack or may include three or more emission stacks.

A first emission stack ST1 may include a first hole control layer HTR1, a first emitting layer EML1, and a first electron control layer ETR1. The first emitting layer EML1 may be located between the first hole control layer HTR1 and the first electron control layer ETR1. The first hole control layer HTR1 may include at least one of a first hole injection layer HIL1 or a first hole transport layer HTL1. The first hole transport layer HTL1 may include at least one of a first hole buffer layer or a first electron-blocking layer. The first electron control layer ETR1 may include at least one of a first electron injection layer EIL1 and a first electron transport layer ETL1. The first electron control layer ETR1 may further include a first hole-blocking layer.

The second emission stack ST2 may include a second hole control layer HTR2, a second emitting layer EML2, and a second electron control layer ETR2. The second emitting layer EML2 may be located between the second hole control layer HTR2 and the second electron control layer ETR2. The second hole control layer HTR2 may include at least one of a second hole injection layer HIL2 or a second hole transport layer HTL2. The second electron control layer ETR2 may include at least one of a second electron injection layer EIL2 or a second electron transport layer ETL2.

In one or more embodiments of the present disclosure, the light emitted from each of the emission stacks ST1 and ST2 may be light of the same wavelength. For example, the light emitted from each of the emission stacks ST1 and ST2 may be blue light. However, the present disclosure is not limited thereto, and wavelength ranges of the lights emitted from each of the emission stacks ST1 and ST2 may be different from each other. For example, at least one of the emission stacks ST1 or ST2 may emit blue light, and the other one may emit green light. The light-emitting element ED including emission stacks ST1 and ST2 that emit the lights of different wavelength ranges may emit white light.

A charge-generating layer CGL may be located between the first emission stack ST1 and the second emission stack ST2. When a voltage is applied, the charge-generating layer CGL may generate charges (electrons and holes) by forming a complex through an oxidation-reduction reaction. Furthermore, the charge-generating layer CGL may provide the generated charges to each of the emission stacks ST1 and ST2. The charge-generating layer CGL may double the current efficiency generated in each of the emission stacks ST1 and ST2, and may serve to control the balance of charges between the first emission stack ST1 and the second emission stack ST2.

For example, the charge-generating layer CGL may have a layer structure, in which a lower charge-generating layer CGL-1 and an upper charge-generating layer CGL-2 are bonded to each other. The lower charge-generating layer CGL-1 may be an n-type charge-generating layer that is located adjacent to the first emission stack ST1, and that provides electrons to the first emission stack ST1. The lower charge-generating layer CGL-1 may include an organic compound of the aryl amine series.

The upper charge-generating layer CGL-2 may be a p-type charge-generating layer that is located adjacent to the second emission stack ST2, and that provides holes to the second emission stack ST2. The upper charge-generating layer CGL-2 may include a charge-generating compound made of a metal, an oxide, a carbide, a fluoride, or a mixture thereof of the metal.

A buffer layer may be further located between the lower charge-generating layer CGL-1 and the upper charge-generating layer CGL-2.

According to one or more embodiments of the present disclosure, the first emission stack ST1, the charge-generating layer CGL, and the second emission stack ST2 may be commonly formed in a plurality of pixels PX by using an open mask. However, the present disclosure is not limited thereto, and at least one of the first or second hole control layers HTR1 or HTR2, the first or second emitting layers EML1 or EML2, or the first or second electron control layers ETR1 or ETR2 may be patterned through the mask to be formed. For example, each of the first and second emission layers EML1 and EML2 may be located in a corresponding opening OP. That is, each of the first and second emission layers EML1 and EML2 may be formed separately in each of the pixels PX.

The second electrode CE may be located on the second emission stack ST2. The second electrode CE may be integrally located in a plurality of pixels PX in common.

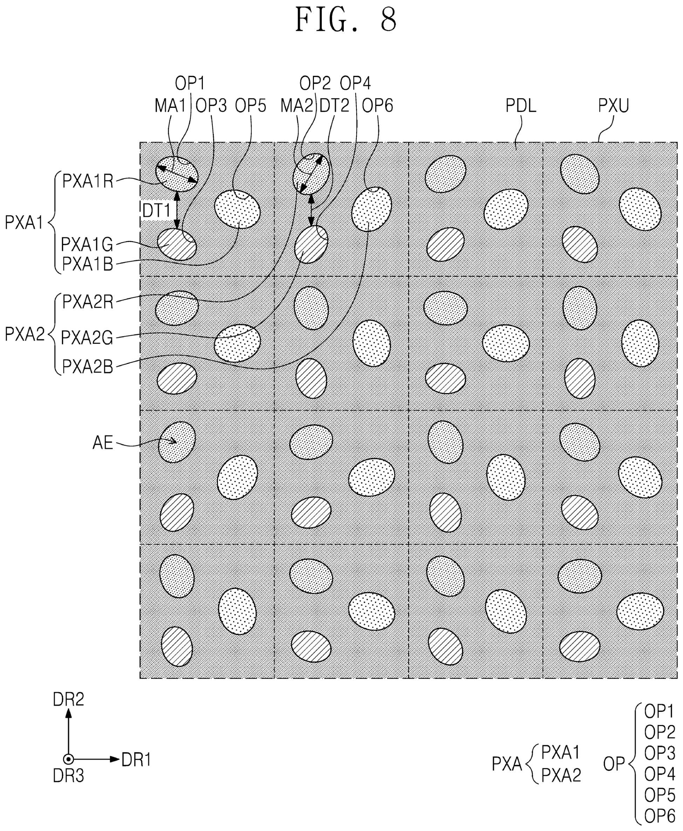

FIG. 8 is a plan view illustrating openings and a plurality of first electrodes AE defined in a pixel definition film PDL according to one or more embodiments of the present disclosure.

FIG. 8 illustrates an example of dotted lines that divide a plurality of pixel units PXU. A white image may be implemented by combining the lights output from the pixels PX included in each of the plurality of pixel units PXU. FIG. 8 illustrates an example of a total of sixteen pixel units PXU.

Referring to FIGS. 6 and 8, a plurality of openings OP may be defined in the pixel definition film PDL. The openings OP may overlap the first electrodes AE in a one-to-one correspondence. Portions of the first electrodes AE, which are exposed by the openings OP, may correspond to emission areas PXA.

In one or more embodiments of the present disclosure, the openings OP of the pixel units PXU may have shapes that are inclined at different angles. Furthermore, the emission areas PXA of the pixel units PXU may also have shapes that are inclined at different angles. That is, the shapes of the openings OP and the emission areas PXA of sixteen pixel units PXU may be located at random rather than regularly. Furthermore, the minimum interval between adjacent emission areas PXA might not be uniform, but instead may be random. That is, because the emission areas PXA are located at random, there may be reduced or eliminated a phenomenon in which a reflection color perceived from a corresponding direction when the electronic device EDE is turned on and off stands out as a corresponding color. For example, when the electronic device EDE is in an off state, the electronic device EDE may be perceived as black without having a corresponding color.

Furthermore, in one or more embodiments of the present disclosure, the openings OP and the emission areas PXA in the plurality of pixel units PXU have irregular random shapes (or degrees of rotation), but the plurality of pixel units PXU may be located repeatedly in the display layer 100 (see FIG. 5).

The emission areas PXA may include first emission areas PXA1 and second emission areas PXA2.

The first emission areas PXA1 may include a first color emission area PXA1R, a second color emission area PXA1G, and a third color emission area PXA1B. The second emission areas PXA2 may include a first color emission area PXA2R, a second color emission area PXA2G, and a third color emission area PXA2B. The first color, the second color, and the third color may be different colors. For example, the first color may be red, the second color may be green, and the third color may be blue.

The first color emission area PXA1R may be referred to as a (1-1)-th sub-emission area PXA1R, the second color emission area PXA1G may be referred to as a (1-2)-th sub-emission area PXA1G, and the third color emission area PXA1B may be referred to as a (1-3)-th sub-emission area PXA1B. Furthermore, the first color emission area PXA2R may be referred to as a (2-1)-th sub-emission area PXA2R, the second color emission area PXA2G may be referred to as a (2-2)-th sub-emission area PXA2G, and the third color emission area PXA2B may be referred to as a (2-3)-th sub-emission area PXA2B.

The (1-1)-th sub-emission area PXA1R may be referred to as a first-first sub-emission area PXA1R, the (1-2)-th sub-emission area PXA1G may be referred to as a first-second sub-emission area PXA1G, and the (1-3)-th sub-emission area PXA1B may be referred to as a first-third sub-emission area PXA1B. The (2-1)-th sub-emission area PXA2R may be referred to as a second-first sub-emission area PXA2R, the (2-2)-th sub-emission area PXA2G may be referred to as a second-second sub-emission area PXA2G, and the (2-3)-th sub-emission area PXA2B may be referred to as a second-third sub-emission area PXA2B.

The openings OP may include a first opening OP1 that defines a (1-1)-th sub-emission area PXA1R, a second opening OP2 that defines a (2-1)-th sub-emission area PXA2R, a third opening OP3 that defines a (1-2)-th sub-emission area PXA1G, a fourth opening OP4 that defines a (2-2)-th sub-emission area PXA2G, a fifth opening OP5 that defines a (1-3)-th sub-emission area PXA1B, and a sixth opening OP6 that defines a (2-3)-th sub-emission area PXA2B.

When viewed on a plane, each of the first to sixth openings OP1, OP2, OP3, OP4, OP5, and OP6 may have an elliptical shape. The first opening OP1 and the second opening OP2 may be areas that emit the same first color light and may have the same size. The third opening OP3 and the fourth opening OP4 may be areas that emit the same second color light and may have the same size. The fifth opening OP5 and the sixth opening OP6 may be areas that emit the same third color light and may have the same size. The first opening OP1, the third opening OP3, and the fifth opening OP5 may be of the same size or may have different sizes. That is, the light-emitting element ED may include a first light-emitting element and a second light-emitting element that emit light of the same color and correspond to the first emission area PXA1 and the second emission area PXA2, respectively.

When viewed on a plane, the first opening OP1 and the second opening OP2 may have shapes that are inclined at different angles. For example, the direction of the major axis MA1 of the first opening OP1 and the direction of the major axis MA2 of the second opening OP2 may be different from each other. Furthermore, the third opening OP3 and the fourth opening OP4 may have shapes that are inclined at different angles, and the fifth opening OP5 and the sixth opening OP6 may have shapes that are inclined at different angles.

The (1-1)-th sub-emission area PXA1R defined by the first opening OP1 and the (2-1)-th sub-emission area PXA2R defined by the second opening OP2 may have shapes that are inclined at different angles. The major axis of the (1-1)-th sub-emission area PXA1R may correspond to the major axis MA1 of the first opening OP1, and the major axis of the (2-1)-th sub-emission area PXA2R may correspond to the major axis MA2 of the second opening OP2.

In one or more embodiments of the present disclosure, the directions of the major axes of the first opening OP1, the third opening OP3, and the fifth opening OP5 may be the same. However, this is only an example, and the present disclosure is not particularly limited thereto. For example, the directions of the major axes of the first opening OP1, the third opening OP3, and the fifth opening OP5 may be different from each other.

The first opening OP1 and the third opening OP3 are adjacent to each other, and the second opening OP2 and the fourth opening OP4 may be adjacent to each other. A first distance DT1 between the first opening OP1 and the third opening OP3 and a second distance DT2 between the second opening OP2 and the fourth opening OP4 may be different from each other. The first distance DT1 and the second distance DT2 may be a minimum distance.

Furthermore, a first interval between a (1-1)-th sub-emission area PXA1R defined by the first opening OP1 and a (1-2)-th sub-emission area PXA1G defined by the third opening OP3 may correspond to the first distance DT1, and a second interval between a (2-1)-th sub-emission area PXA2R defined by the second opening OP2 and a (2-2)-th sub-emission area PXA2G defined by the fourth opening OP4 may correspond to a second distance DT2. Accordingly, the first interval and the second interval may be different from each other.

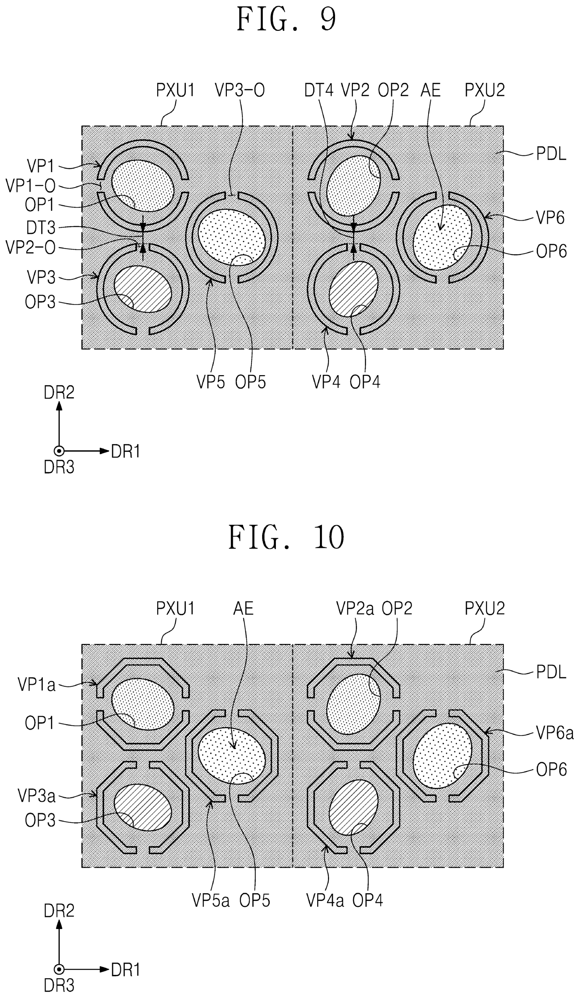

According to one or more embodiments of the present disclosure, a separation pattern VP for reducing or preventing a lateral leakage current generated by a functional layer commonly provided between adjacent pixels PX may be provided on a pixel definition film PDL. In the specification, the term "lateral leakage current" refers to current that flows in other directions that cross the third direction DR3, other than current that flows in the third direction DR3 that is a lamination direction of light-emitting elements ED, that is, a direction, in which an image is displayed. The lateral leakage current may refer to current that flows in a direction that is parallel to a plane defined by the first direction DR1 and the second direction DR2. In the display device according to one or more embodiments of the present disclosure, because a separation pattern VP that is recessed in the thickness direction of the pixel definition film PDL is defined, generation of lateral leakage current may be reduced or prevented, color mixing between adjacent emission areas PXA may be reduced or prevented, and degradation of brightness may be reduced or prevented. Hereinafter, embodiments of the separation pattern VP will be described with reference to FIGS. 9 to 12.

FIG. 9 is a plan view illustrating openings, separation patterns, and a plurality of first electrodes AE defined in a pixel definition film PDL according to one or more embodiments of the present disclosure.

Referring to FIGS. 6, 8, and 9, a first separation pattern VP1 that surrounds at least a portion of the first opening OP1, and a second separation pattern VP2 that surrounds at least a portion of the second opening OP2, may be provided on (e.g., above) the upper surface of a pixel definition film PDL. Furthermore, a third separation pattern VP3 that surrounds at least a portion of the third opening OP3, and a fourth separation pattern VP4 that surrounds at least a portion of the fourth opening OP4, may be further provided on the upper surface of the pixel definition film PDL. Furthermore, a fifth separation pattern VP5 that surrounds at least a portion of the fifth opening OP5, and a sixth separation pattern VP6 that surrounds at least a portion of the sixth opening OP6, may be further provided on the upper surface of the pixel definition film PDL.

The shapes of the first, third, and fifth openings OP1, OP3, and OP5 and the shapes of the second, fourth, and sixth openings OP2, OP4, and OP6 may not be completely the same. For example, the first, third, and fifth openings OP1, OP3, and OP5 may be inclined at different angles from those of the second, fourth, and sixth openings OP2, OP4, and OP6.

According to one or more embodiments of the present disclosure, regardless of the differences in the shapes (or the difference in the disposition angles) of the first, third, and fifth openings OP1, OP3, and OP5 and the second, fourth, and sixth openings OP2, OP4, and OP6, the shape of the first separation pattern VP1 may be the same as the shape of the second separation pattern VP2, the shape of the third separation pattern VP3 may be the same as the shape of the fourth separation pattern VP4, and the shape of the fifth separation pattern VP5 may be the same as the shape of the sixth separation pattern VP6. Accordingly, a third distance DT3 between the first separation pattern VP1 and the third separation pattern VP3, and a fourth distance DT4 between the second separation pattern VP2 and the fourth separation pattern VP4, may be the same.

According to one or more embodiments of the present disclosure, even when the distances between the openings OP1, OP3, and OP5 in one pixel unit PXU1 and the distances between the openings OP2, OP4, and OP6 in another pixel unit PXU2 are different, the shapes of the separation patterns VP1, VP3, and VP5 in one pixel unit PXU1 may be respectively the same as the shapes of the separation patterns VP2, VP4, and VP6 in the other pixel unit PXU2. That is, the diffusion of the lateral leakage current that occurs between adjacent openings is blocked by the separation patterns having the same shape. Accordingly, the lateral leakage current may be controlled to a substantially equivalent level between the pixel units. Accordingly, the display quality of the electronic device EDE (see FIG. 1) may be improved.

The first, third, and fifth separation patterns VP1, VP3, and VP5 may be adjacent to non-pattern areas VP1-O, VP2-O, and VP3-O, in which no recessed shape is provided. The second, fourth, and sixth separation patterns VP2, VP4, and VP6 have completely or substantially the same shapes as those of the first, third, and fifth separation patterns VP1, VP3, and VP5, and thus, a description thereof will be omitted. When viewed on a plane, each of the first, third, and fifth separation patterns VP1, VP3, and VP5 may have a shape of a portion of a circular ring. The remaining portions of the circular ring may correspond to the non-pattern areas VP1-O, VP2-O, and VP3-O.

The non-pattern areas VP1-O, VP2-O, and VP3-O may be provided to reduce or prevent the driving voltage from increasing excessively. Accordingly, a decrease in luminance may be reduced or prevented, and the display efficiency of the electronic device EDE (see FIG. 1) may be improved. The non-pattern areas VP1-O, VP2-O, and VP3-O may be defined not to face each other. Accordingly, even when a lateral leakage current occurs through the non-pattern areas VP1-O, VP2-O, and VP3-O, color mixing between adjacent pixels PX may be reduced or prevented because the non-pattern areas VP1-O, VP2-O, and VP3-O do not face each other.

FIG. 10 is a plan view illustrating openings, separation patterns, and a plurality of first electrodes AE defined in a pixel definition film PDL according to one or more embodiments of the present disclosure.

Referring to FIGS. 8 and 10, a first separation pattern VP1a that surrounds at least a portion of the first opening OP1, and a second separation pattern VP2a that surrounds at least a portion of the second opening OP2, may be provided on (e.g., above) the upper surface of a pixel definition film PDL. Furthermore, a third separation pattern VP3a that surrounds at least a portion of the third opening OP3, and a fourth separation pattern VP4a that surrounds at least a portion of the fourth opening OP4, may be further provided on the upper surface of the pixel definition film PDL. Furthermore, a fifth separation pattern VP5a that surrounds at least a portion of the fifth opening OP5, and a sixth separation pattern VP6a that surrounds at least a portion of the sixth opening OP6, may be further provided on the upper surface of the pixel definition film PDL.

When viewed on a plane, each of the first to sixth separation patterns VP1a, VP2a, VP3a, VP4a, VP5a, and VP6a may have a shape of a portion of a polygonal ring. FIG. 10 illustrates as an example that each of the first to sixth separation patterns VP1a, VP2a, VP3a, VP4a, VP5a, and VP6a has a shape of a portion of an octagonal ring, but the present disclosure is not particularly limited thereto. For example, each of the first to sixth separation patterns VP1a, VP2a, VP3a, VP4a, VP5a, and VP6a may be modified into various shapes, such as a portion of a square ring, a pentagonal ring, or a hexagonal ring.

According to one or more embodiments of the present disclosure, even when the distances between the openings OP1, OP3, and OP5 in one pixel unit PXU1 and the distances between the openings OP2, OP4, and OP6 in another pixel unit PXU2 are different, the shapes of the separation patterns VP1a, VP3a, and VP5a in one pixel unit PXU1 may be respectively the same as the shapes of the separation patterns VP2a, VP4a, and VP6a in the other pixel unit PXU2. That is, the diffusion of the lateral leakage current that occurs between adjacent openings is blocked by the separation patterns having the same shape. Accordingly, the lateral leakage current may be controlled to a substantially equivalent level between the pixel units. Accordingly, the display quality of the electronic device EDE (see FIG. 1) may be improved.

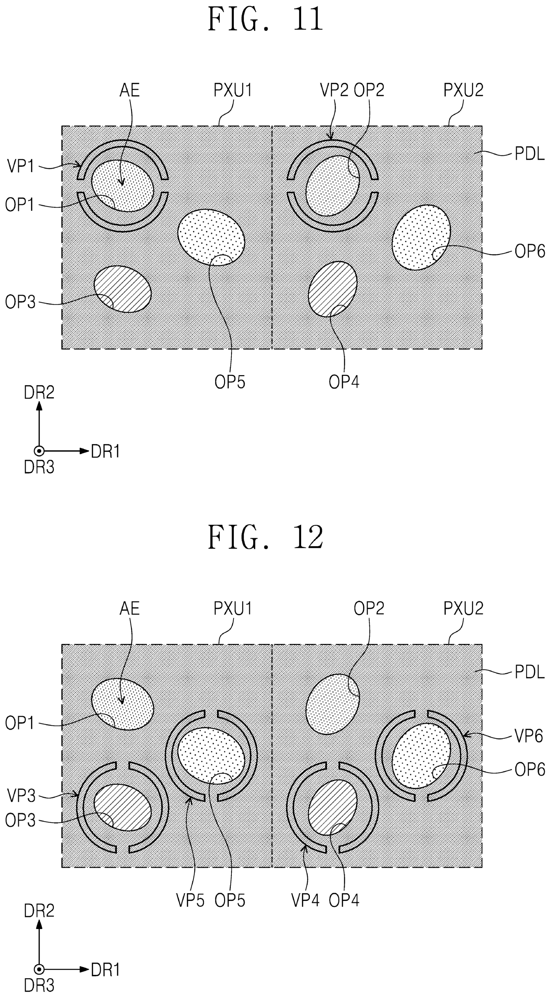

FIG. 11 is a plan view illustrating openings, separation patterns, and a plurality of first electrodes AE defined in a pixel definition film PDL according to one or more embodiments of the present disclosure.

Referring to FIGS. 8 and 11, a first separation pattern VP1 that surrounds at least a portion of the first opening OP1, and a second separation pattern VP2 that surrounds at least a portion of the second opening OP2, may be provided on the upper surface of a pixel definition film PDL.

According to one or more embodiments of the present disclosure, a separation pattern that surrounds at least a portion of each of the third opening OP3, the fourth opening OP4, the fifth opening OP5, and the sixth opening OP6 may be omitted. The first separation pattern VP1 may be located between the first opening OP1 and the third opening OP3, and between the first opening OP1 and the fifth opening OP5.

According to one or more embodiments of the present disclosure, even when the distances between the openings OP1, OP3, and OP5 in one pixel unit PXU1 and the distances between the openings OP2, OP4, and OP6 in another pixel unit PXU2 are different, the shapes of the first separation pattern VP1 in one pixel unit PXU1 may be the same as the shapes of the second separation pattern VP2 in the other pixel unit PXU2. Accordingly, a deviation in the distance between the openings of the pixel units may be reduced by the first and second separation patterns VP1 and VP2 having the same shape.

FIG. 12 is a plan view illustrating openings, separation patterns, and a plurality of first electrodes AE defined in a pixel definition film PDL according to one or more embodiments of the present disclosure.

Referring to FIGS. 8 and 12, a third separation pattern VP3 that surrounds at least a portion of the third opening OP3, and a fourth separation pattern VP4 that surrounds at least a portion of the fourth opening OP4, may be provided on the upper surface of the pixel definition film PDL. Furthermore, a fifth separation pattern VP5 that surrounds at least a portion of the fifth opening OP5, and a sixth separation pattern VP6 that surrounds at least a portion of the sixth opening OP6, may be further provided on the upper surface of the pixel definition film PDL.

According to one or more embodiments of the present disclosure, a separation pattern that surrounds at least a portion of each of the first opening OP1 and the second opening OP2 may be omitted. The third separation pattern VP3 and the fifth separation pattern VP5 may be located between the third opening OP3 and the fifth opening OP5, and only the third separation pattern VP3 may be located between the first opening OP1 and the third opening OP3.

According to one or more embodiments of the present disclosure, even when the distances between the openings OP1, OP3, and OP5 in one pixel unit PXU1 and the distances between the openings OP2, OP4, and OP6 in another pixel unit PXU2 are different, the shapes of the third and fifth separation patterns VP3 and VP5 in one pixel unit PXU1 may be respectively the same as the shapes of the fourth and sixth separation patterns VP4 and VP6 in the other pixel unit PXU2. Accordingly, a deviation in the distances between the openings between the pixel units may be reduced by the third and fifth separation patterns VP3 and VP5 and the fourth and sixth separation patterns VP4 and VP6 having the same shapes at corresponding positions.

According to the embodiments illustrated in FIGS. 11 and 12, separation patterns may not be provided to all openings in a one-to-one correspondence, but may be provided only to some openings. In this case, a degree of freedom of design of the openings of the pixel definition film PDL or a degree of freedom of design of the separation pattern may be improved.

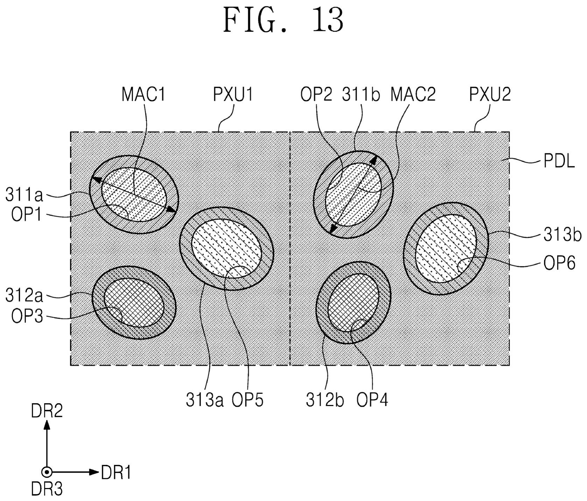

FIG. 13 is a plan view illustrating openings and color filters 320 (see FIG. 6) defined in a pixel definition film PDL according to one or more embodiments of the present disclosure.

Referring to FIG. 6 and FIG. 13, the plurality of color filters 320 may include a first color filter 311a that overlaps the first opening OP1, a second color filter 311b that overlaps the second opening OP2, a third color filter 312a that overlaps the third opening OP3, a fourth color filter 312b that overlaps the fourth opening OP4, a fifth color filter 313a that overlaps the fifth opening OP5, and a sixth color filter 313b that overlaps the sixth opening OP6.

The first color filter 311a and the second color filter 311b may transmit a first color light, the third color filter 312a and the fourth color filter 312b may transmit a second color light, and the fifth color filter 313a and the sixth color filter 313b may transmit a third color light. The first color light may be red light, the second color light may be green light, and the third color light may be blue light, but the present disclosure is not particularly limited thereto.

When viewed on a plane, each of the first to sixth color filters 311a, 311b, 312a, 312b, 313a, and 313b may have an elliptical shape. Furthermore, when viewed on a plane, the first color filter 311a and the second color filter 311b may have shapes that are inclined at different angles. For example, the direction of the major axis MAC1 of the first color filter 311a and the direction of the major axis MAC2 of the second color filter 311b may be different from each other.

As described with reference to FIG. 13, the shapes of the first to sixth color filters 311a, 311b, 312a, 312b, 313a, and 313b may be located at random rather than regularly. Accordingly, a phenomenon, in which a reflected color perceived from a corresponding direction stands out as a corresponding color when the electronic device EDE is switched on and off, may be reduced or eliminated. For example, when the electronic device EDE is in an off state, the electronic device EDE may be perceived as black without having a corresponding color.

As described above, the shapes of the openings defined in the pixel definition film in a plurality of pixel units may be arranged at random rather than regularly. Accordingly, a phenomenon, in which a reflected color perceived from a corresponding direction stands out as a corresponding color when the electronic device is switched on and off, may be reduced or eliminated. In addition, regardless of whether the shapes of the openings are different, the separation patterns that surround at least a portion of the openings may be arranged according to the same rule. That is, the diffusion of the lateral leakage current that occurs between adjacent openings is blocked by the separation patterns arranged in the same rule. The lateral leakage current may be controlled to a substantially equivalent level between the pixel units. Accordingly, the display quality of the electronic device may be improved.

Although one or more embodiments of the present disclosure has been described for illustrative purposes, those skilled in the art will appreciate that various modifications, and substitutions are possible, without departing from the scope of the present disclosure as defined by the appended claims.

Accordingly, the technical scope of the present disclosure is not limited to the detailed description of this specification, but is defined by the appended claims.

## Claims

1. An electronic device (EDE, 10_3) comprising:
a base layer (110);
a circuit layer (120) above the base layer (110);
a light-emitting element layer (130) above the circuit layer (120), and comprising:
pixel electrodes (CE, AE); and
a pixel definition film (PDL) defining openings (OP) respectively overlapping the pixel electrodes (CE, AE), the openings (OP) comprising a first opening (OP1) and a second opening (OP2) having shapes inclined at different angles in plan view; and
a first separation pattern (VP1) surrounding at least a portion of the first opening (OP1), and a second separation pattern (VP2) surrounding at least a portion of the second opening (OP2), above an upper surface of the pixel definition film (PDL), the first separation pattern (VP1) and the second separation pattern (VP2) having a same shape.

2. The electronic device (EDE, 10_3) of claim 1, wherein the first opening (OP1) and the second opening (OP2) have an elliptical shape, and
wherein a direction of a major axis (MA1) of the first opening (OP1) is different from a direction of a major axis (MA2) of the second opening (OP2).

3. The electronic device (EDE, 10_3) of claims 1 or 2, wherein the first separation pattern (VP1) and the second separation pattern (VP2) have a shape of a portion of a circular ring or a portion of a polygonal ring in plan view.

4. The electronic device (EDE, 10_3) of any one of claims 1 to 3, wherein the openings (OP) further comprise:
a third opening (OP3) adjacent to the first opening (OP1); and
a fourth opening (OP4) adjacent to the second opening (OP2) and having a shape inclined at a different angle from that of the third opening (OP3).

5. The electronic device (EDE, 10_3) of claim 4, further comprising:
a third separation pattern (VP3) surrounding at least a portion of the third opening (OP3), and a fourth separation pattern (VP4) surrounding at least a portion of the fourth opening (OP4) and having the same shape as that of the third separation pattern (VP3), above the upper surface of the pixel definition film (PDL).

6. The electronic device (EDE, 10_3) of claim 4 or 5, wherein a first distance (DT1) between the first opening (OP1) and the third opening (OP3) is different from a second distance (DT2) between the second opening (OP2) and the fourth opening (OP4).

7. The electronic device (EDE, 10_3) of any one of claims 4 to 6, wherein a third distance (DT3) between the first separation pattern (VP1) and the third separation pattern (VP3) is substantially equal to a fourth distance (DT4) between the second separation pattern (VP2) and the fourth separation pattern (VP4).

8. The electronic device (EDE, 10_3) of any one of claims 1 to 3, wherein the openings (OP) further comprise a third opening (OP3) adjacent to the first opening (OP1) and a fifth opening (OP5) adjacent to the first opening (OP1).

9. The electronic device (EDE, 10_3) of claim 8, wherein the first separation pattern (VP1) is between the first opening (OP1) and the third opening (OP3) and between the first opening (OP1) and the fifth opening (OP5).

10. The electronic device (EDE, 10_3) of claim 8 or 9, wherein the electronic device (EDE, 10_3) further comprises a third separation pattern (VP3) surrounding at least a portion of the third opening (OP3) above the upper surface of the pixel definition film (PDL).

11. The electronic device (EDE, 10_3) of claim 10, wherein the first separation pattern (VP1) and the third separation pattern (VP3) are between the first opening (OP1) and the third opening (OP3).

12. The electronic device (EDE, 10_3) of claim 10 or 11, wherein the first separation pattern (VP1) is between the first opening (OP1) and the fifth opening (OP5).

13. The electronic device (EDE, 10_3) of any one of claims 8 to 12, wherein the first opening (OP1) and the second opening (OP2) correspond to a first color emission area (PXA1R) of a first color,
wherein the third opening (OP3) corresponds to a second color emission area of a second color (PXA1G) different from the first color, and
wherein the fifth opening (OP5) corresponds to a third color emission area (PXA1B) of a third color different from the first color and from the second color.

14. The electronic device (EDE, 10_3) of any one of the preceding claims, further comprising a reflection reduction layer (300) above the light-emitting element layer (130), the reflection reduction layer (300) comprising color filters (320) comprising a first color filter (311a) overlapping the first opening (OP1) and a second color filter (311b) overlapping the second opening (OP2),
wherein the first color filter (311a) and the second color filter (311b) have shapes inclined at different respective angles in plan view.

15. The electronic device (EDE, 10_3) of claim 14, wherein the first color filter (311a) and the second color filter (311b) have an elliptical shape, and
wherein a direction of a major axis (MAC1) of the first color filter (311a) is different from a direction of a major axis (MAC2) of the second color filter (311b).
